(19) Europäisches Patentamt
European Patent Office
Office européen des brevets

(11) **EP 1 544 998 A2**

(12) **EUROPEAN PATENT APPLICATION**

(43) Date of publication:
**22.06.2005 Bulletin 2005/25**

(51) Int Cl.7: **H03H 9/02**

(21) Application number: **04029592.5**

(22) Date of filing: **14.12.2004**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **15.12.2003 JP 2003415839**

(71) Applicant: **ALPS ELECTRIC CO., LTD.**
**Tokyo 145-8501 (JP)**

(72) Inventors:
• **Ozaki, Kyosuke**
  **Ota-ku Tokyo 145-8501 (JP)**

• **Ozaki, Hideyuki**
  **Ota-ku Tokyo 145-8501 (JP)**
• **Sato, Takashi**
  **Ota-ku Tokyo 145-8501 (JP)**
• **Waga, Satoshi**
  **Ota-ku Tokyo 145-8501 (JP)**
• **Ikeda, Takeshi**
  **Ota-ku Tokyo 145-8501 (JP)**

(74) Representative: **Klunker . Schmitt-Nilson . Hirsch**
  **Winzererstrasse 106**
  **80797 München (DE)**

(54) **Surface acoustic wave device and manufacturing method thereof**

(57)    There is provided a surface acoustic wave device having an excellent temperature characteristic and an excellent resonance characteristic. A piezoelectric substrate 12 and interdigital electrode portions 13 and 14 are covered with an insulating layer 21 with an insulating thin film 20 interposed therebetween. The piezoelectric substrate 12 is made of LiTaO₃ and the insulating thin film 20 and the insulating layer 21 are made of silicon oxide. By intentionally making the upper surface of the insulating layer 21 flat, the deterioration of propagation efficiency of surface acoustic waves can be suppressed, so that it is possible to reduce increase in insertion loss of a resonator. Since the upper surface 21a of the insulating layer 21 is flat, it is also possible to reduce variation in resonant frequency and anti-resonant frequency due to the temperature change of the surface acoustic wave device.

FIG. 2

EP 1 544 998 A2

**Description**

BACKGROUND OF THE INVENTION

1. Field of the Invention

The present invention relates to a surface acoustic wave device capable of improving a temperature characteristic at a high-frequency band and a manufacturing method thereof.

2. Description of the Related Art

Surface acoustic wave devices are electronic components using surface acoustic waves which are propagated in a state where mechanical vibration energy is concentrated only around surfaces of solid substances, and are used to construct filters, resonators, duplexers, etc.

Recently, decrease in size and decrease in weight of mobile communication terminals such as mobile phones have been advanced, and thus decrease in size of electronic components mounted on the mobile communication terminals has been required.

A surface acoustic wave device has a structure where a pair of interdigital electrodes (IDT (InterDigital Transducer) electrodes) made of a conductive material having a small specific gravity is opposed to each other on a piezoelectric substrate and fingers thereof are alternately arranged. The surface acoustic wave device having such a simple structure is suitable to decrease the mobile communication terminals.

When the surface acoustic wave device is used as a resonator, it is important that variation of a serial resonant frequency and a parallel resonant frequency should be small when the device temperature is changed.

EP0734120A1 discloses that the variation of the serial resonant frequency and the parallel resonant frequency when the device temperature is changed can be reduced by covering the interdigital electrodes and the piezoelectric substrate with a silicon oxide film.

However, the surface acoustic wave device and the manufacturing method thereof disclosed in EP0734120A1 have the following problems.

In the surface acoustic wave device disclosed in EP0734120A1, an $SiO_2$ film covering the surface is formed using a sputtering method. In Fig. 1 of EP0734120A1, the upper surface of the $SiO_2$ film is indicated by a straight line and the upper surface of the $SiO_2$ film looks flat. However, such figure is only a schematic diagram and does not reflect the surface structure of the actual surface acoustic wave device.

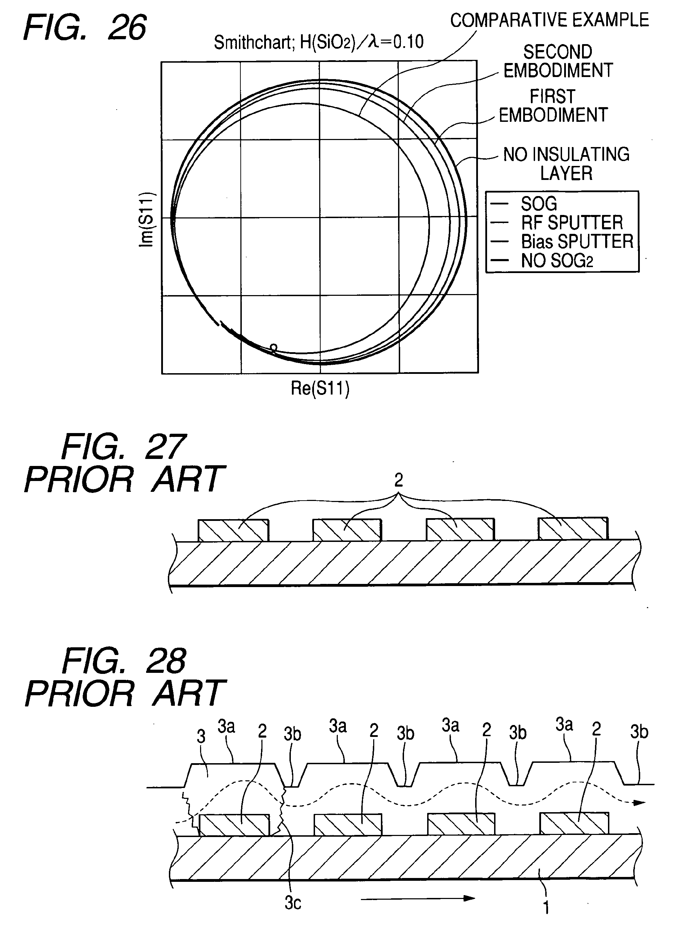

The sectional structure of a conventional surface acoustic wave device of which the surface is covered with an insulating material is now described with reference to Figs. 27 and 28. Fig. 27 is a cross-sectional view illustrating a state where interdigital electrodes 2 are formed on a piezoelectric substrate 1 by etching a sputtered film. The piezoelectric substrate 1 is made of, for example, $LiTaO_3$ and the interdigital electrodes 2 are made of, for example, Cu.

After forming the interdigital electrode 2, an SiO2 film 3 is formed using a sputtering method. Then, unlike the drawings of EP0734120A1, actually as shown in Fig. 28, convex portions 3a on the interdigital electrode 2 and concave portions 3b on between the interdigital electrodes 2 are formed on the surface of the SiO2 film 3

In this way, when the convex portions 3a and the concave portions 3b are formed on the surface of the SiO2 film 3, propagation efficiency of surface acoustic waves propagated in the arrow direction is deteriorated, so that energy loss of the resonator is increased. In addition, when the SiO2 film 3 is formed using an RF sputtering method, cracks 3c or voids are formed at the inside of the SiO2 film 3, specifically around the interdigital electrodes 2, whereby the propagation efficiency of the surface acoustic waves is deteriorated, thereby increasing the energy loss of the resonator.

SUMMARY OF THE INVENTION

The present invention is contrived to solve the above conventional problems, and it is an object of the present invention to provide a surface acoustic wave device capable of improving a temperature characteristic and keeping an excellent resonance characteristic and a manufacturing method thereof.

According to an aspect of the present invention, there is provided a surface acoustic wave device having a piezoelectric substrate and an interdigital electrode portion formed thin on the piezoelectric substrate, wherein the piezoelectric substrate is covered with an insulating layer made of an insulating material having a temperature-elasticity constant variation characteristic opposite to the temperature-elasticity constant variation characteristic of the piezoelectric substrate, and the upper surface of the insulating layer is flat.

According to the present invention, since the piezoelectric substrate is covered with the insulating layer, the variation of a serial resonant frequency and a parallel resonant frequency can be reduced when the device temperature is changed. In addition, the upper surface of the insulating layer is made flat.

When the upper surface of the insulating layer is flat, the deterioration of the propagation efficiency of surface acoustic waves can be suppressed, so that it is possible to reduce increase of the insertion loss of a resonator. Further, when the upper surface of the insulating layer is flat, it is possible to reduce the variation of the resonant frequency and the anti-resonant frequency due to the temperature change of the surface acoustic wave device, compared to the conventional case where unevenness having large steps is formed on the upper surface of the insulating layer.

In the present invention, the interdigital electrode portion may be covered with the insulating layer and the upper surface of the insulating layer may be flat.

When the thickness of the interdigital electrode portion is denoted by T and a difference between the maximum and the minimum of the thickness from the upper surface of the piezoelectric substrate to the upper surface of the insulating layer is denoted by h, the rate of flatness S (%) of the upper surface of the insulating layer expressed by the following equation may be 50% or more.

$$S = \left(1 - \frac{h}{T}\right) \times 100 \ (\%)$$

In the present invention, the insulating layer may be a thin film having a uniform density. In the present invention, "the insulating layer has a uniform density" means that voids or cracks do not exist at the inside of the insulating layer, specifically, around the interdigital electrode portion, and the insulating material occupies the whole space.

When the wavelength of a surface wave propagated through the surface of the piezoelectric substrate is denoted by $\lambda$ and the maximum value of the thickness ranging from the upper surface of the piezoelectric substrate to the upper surface of the insulating layer is denoted by H, a normalized thickness $H/\lambda$ of the insulating layer may have a range of $0 < H/\lambda < 0.5$.

Specifically, when the normalized thickness $H/\lambda$ of the insulating layer is 0.06 or more, the absolute value of the variation of the anti-resonant frequency per temperature change of 1°C of the surface acoustic wave device can be set to 30 ppm/°C or less. When the normalized thickness $H/\lambda$ of the insulating layer is 0.08 or less, the reflection coefficient $S_{11}$ at the anti-resonant frequency of the surface acoustic wave device can be set to 0.9 or more.

An insulating thin film formed using a sputtering method may exist between the interdigital electrode portion and piezoelectric substrate and the insulating layer, and when the wavelength of the surface wave propagated through the surface of the piezoelectric substrate is denoted by $\lambda$ and the thickness of the insulating thin film is denoted by t1, a normalized thickness $t1/\lambda$ of the insulating thin film may have a range of $0 < t1/\lambda < 0.1$. When the insulating thin film is formed, it is possible to suppress the deterioration of the interdigital electrode portion and to improve adhesive power of the insulating layer.

An example of a combination of the piezoelectric substrate and the insulating material of which the temperature-elasticity constant variation characteristics are opposite to each other includes that the piezoelectric substrate is made of, for example, $LiTaO_3$ and the insulating material includes, for example, silicon oxide or aluminum nitride.

According to another aspect of the present invention, there is provided a first method of manufacturing a surface acoustic wave device, the method comprising the steps of: (a) patterning and forming an interdigital electrode portion on a piezoelectric substrate using a conductive material; and (b) coating the piezoelectric substrate with an insulating material having a temperature-elasticity constant variation characteristic opposite to the temperature-elasticity constant variation characteristic of the piezoelectric substrate, forming an insulating layer, and making the insulating layer flat.

According to the present invention described above, a method (spin coating method) of coating the piezoelectric substrate with the insulating material is used to make the upper surface of the insulating layer flat. Conventionally, since there was not any idea of intentionally making the upper surface of the insulating layer covering the piezoelectric substrate flat, a RF sputtering method was used for forming the insulating layer. As a result, unevenness having large steps was formed on the surface of the actual insulating layer, thereby increasing the insertion loss of the surface acoustic wave device.

According to the present invention, since the upper surface of the insulating layer can be surely made flat, the deterioration of the propagation efficiency of the surface acoustic waves can be suppressed, so that it is possible to reduce increase of the insertion loss of the surface acoustic wave device. In addition, when the upper surface of the insulating layer is flat, it is possible to reduce variation of a resonant frequency and an anti-resonant frequency due to the temperature change of the surface acoustic wave device, compared to the conventional case where the unevenness having large steps is formed on the upper surface of the insulating layer.

According to another aspect of the present invention, there is provided a second method of manufacturing a surface acoustic wave device, the method comprising the steps of: (e) patterning and forming an interdigital electrode portion on a piezoelectric substrate using a conductive material; (f) coating the piezoelectric substrate with an insulating material having a temperature-elasticity constant variation characteristic opposite to the temperature-elasticity constant variation characteristic of the piezoelectric substrate, and forming an insulating layer; and (g) polishing or etching the upper surface of the insulating layer to make the upper surface of the insulating layer flat.

After step (b) or step (f), a step of heating the insulating layer may be further performed.

In the present invention, the piezoelectric substrate may be made of $LiTaO_3$ and the insulating layer may be formed using silicon oxide as the insulating material to include silicon compound as a major component.

Alternatively, there is provided a third method of manufacturing a surface acoustic wave device, the method comprising the steps of: (h) patterning and forming an interdigital electrode portion on a piezoelectric substrate using a conductive material; and (i) forming an insulating layer on the piezoelectric substrate using an insulating material having a temperature-elasticity constant variation characteristic opposite to the temperature-elasticity constant variation characteristic of the piezoelectric substrate, by one of a bias sputtering method, a bias CVD method, and an atmospheric CVD method, and making the upper surface of the insulating layer flat. In the present invention in which the insulating layer is formed by one of the bias sputtering method, the biasing CVD method, and the atmospheric CVD method, the piezoelectric substrate may be made of LiTaO3 and silicon oxide or silicon nitride may be used as the insulating material.

Between step (a) and step (b), between step (e) and step (f), and between step (h) and step (i), a step of forming on the interdigital electrode portion and the piezoelectric substrate an insulating thin film having a normalized thickness $t1/\lambda$ ranging $0 < t1/\lambda < 0.1$ using a sputtering method may be further performed. As a result, it is possible to suppress the deterioration of the interdigital electrode portion and to improve adhesive power of the insulating layer. Here, $\lambda$ denotes the wavelength of a surface wave propagated through the surface of the piezoelectric substrate and t1 denotes the thickness of the insulating thin film.

Alternatively, there is provided a method of manufacturing a surface acoustic wave device, the method comprising the steps of: (j) forming on the piezoelectric substrate an insulating layer having a flat upper surface using an insulating material having a temperature-elasticity constant variation characteristic opposite to the temperature-elasticity constant variation characteristic of the piezoelectric substrate; (k) patterning and forming on the surface of the insulating layer a concave portion having a shape of an interdigital electrode portion; and (l) forming the interdigital electrode portion in the concave portion.

After step (l), step (m) of forming another insulating layer on the insulating layer and the interdigital electrode portion using the insulating material and making the upper surface of another insulating layer flat may be further performed.

In the present invention, at step (b), step (f), step (i), step (j), and (m), the insulating layer may be formed as a thin film having a uniform density. In the present invention, "the insulating layer has a uniform density" means that voids or cracks do not exist at the inside of the insulating layer, specifically, around the interdigital electrode portion, and the insulating material occupies the whole space.

Alternatively, there is provided a fourth method of manufacturing a surface acoustic wave device, the method comprising the steps of: (n) patterning and forming an interdigital electrode portion on a piezoelectric substrate using a conductive material; (o) forming on the piezoelectric substrate an insulating layer using an insulating material having a temperature-elasticity constant variation characteristic opposite to the temperature-elasticity constant variation characteristic of the piezoelectric substrate by one of a sputtering method and a CVD method; and (p) polishing or etching the upper surface of the insulating layer to make the upper surface of the insulating layer flat.

In the method of manufacturing a surface acoustic wave device according to the present invention, at step (b), step (e), step (h), step (j), step (m), and step (p), when the thickness of the interdigital electrode portion is denoted by T and a difference between the maximum value and the minimum value of the thickness from the upper surface of the piezoelectric substrate to the upper surface of the insulating layer is denoted by h, the rate of flatness S (%) of the upper surface of the insulating layer expressed by the following equation may be 50% or more.

$$S = \left(1 - \frac{h}{T}\right) \times 100 \ (\%)$$

According to the present invention, the temperature characteristic of the surface acoustic wave device can be improved by covering the piezoelectric substrate with the insulating layer and the deterioration of the propagation efficiency of the surface acoustic waves can be suppressed by making the upper surface of the insulating layer flat, so that it is possible to reduce increase of the insertion loss of a resonator. In addition, when the upper surface of the insulating layer is flat, it is possible to reduce variations of the resonant frequency and the anti-resonant frequency due to the temperature change of the surface acoustic wave device, compared to a case where the unevenness having large steps is formed on the upper surface of the insulating layer.

In the present invention, the method (spin coating method) of coating the piezoelectric substrate with the insulating material, the bias sputtering method, the bias CVD method, or the atmospheric CVD method can be used to make the upper surface of the insulating layer flat.

Alternatively, after forming the insulating layer, the upper surface of the insulating layer can be made flat by polishing or etching the upper surface of the insulating layer.

Alternatively, a method of forming the insulating layer having a flat upper surface and burying the interdigital electrode portion in the insulating layer can be employed.

BRIEF DESCRIPTION OF THE DRAWINGS

Fig. 1 is a plan view illustrating a surface acoustic wave device according to an embodiment of the present invention.

Fig. 2 is a partial cross-sectional view of the surface acoustic wave device taken along Line 2-2 of Fig. 1 and seen in the arrow direction.

Fig. 3 is a schematic diagram illustrating a cut angle of a monocrystalline piezoelectric substrate.

Fig. 4 is a partial cross-sectional view illustrating a step of an embodiment of a method of manufacturing the surface acoustic wave device according to the present invention.

Fig. 5 is a partial cross-sectional view illustrating a step of an embodiment of a method of manufacturing the surface acoustic wave device according to the present invention.

Fig. 6 is a partial cross-sectional view illustrating a step of an embodiment of a method of manufacturing the surface acoustic wave device according to the present invention.

Fig. 7 is a partial cross-sectional view illustrating a step of an embodiment of a method of manufacturing the surface acoustic wave device according to the present invention.

Fig. 8 is a partial cross-sectional view illustrating a step of an embodiment of a method of manufacturing the surface acoustic wave device according to the present invention.

Fig. 9 is a partial cross-sectional view illustrating a step of an embodiment of a method of manufacturing the surface acoustic wave device according to the present invention.

Fig. 10 is a partial cross-sectional view illustrating a step of an embodiment of a method of manufacturing the surface acoustic wave device according to the present invention.

Fig. 11 is a partial cross-sectional view illustrating a step of an embodiment of a method of manufacturing the surface acoustic wave device according to the present invention.

Fig. 12 is a partial cross-sectional view illustrating a step of an embodiment of a method of manufacturing the surface acoustic wave device according to the present invention.

Fig. 13 is a partial cross-sectional view illustrating a step of an embodiment of a method of manufacturing the surface acoustic wave device according to the present invention.

Fig. 14 is a partial cross-sectional view illustrating a step of an embodiment of a method of manufacturing the surface acoustic wave device according to the present invention.

Fig. 15 is a partial cross-sectional view illustrating a step of an embodiment of a method of manufacturing the surface acoustic wave device according to the present invention.

Fig. 16 is a partial cross-sectional view illustrating a step of an embodiment of a method of manufacturing the surface acoustic wave device according to the present invention.

Fig. 17 is a partial cross-sectional view illustrating a step of an embodiment of a method of manufacturing the surface acoustic wave device according to the present invention.

Fig. 18 is a partial cross-sectional view illustrating a step of an embodiment of a method of manufacturing the surface acoustic wave device according to the present invention.

Fig. 19 is an equivalent circuit diagram of a T-type filter formed using the surface acoustic wave device according to the present invention.

Fig. 20 is an equivalent circuit diagram of a $\pi$-type filter formed using the surface acoustic wave device according to the present invention.

Fig. 21 is a cross-sectional photograph of a surface acoustic wave device according to an embodiment of the present invention, in which an insulating layer covering a piezoelectric substrate and an interdigital electrode portion is formed using a spin-on-glass method.

Fig. 22 is a cross-sectional photograph of a surface acoustic wave device according to a comparative example of the present invention, in which the insulating layer covering the piezoelectric substrate and the interdigital electrode portion is formed using a CVD method.

Fig. 23 is a cross-sectional photograph of a surface acoustic wave device according to a comparative example of the present invention, in which the insulating layer covering the piezoelectric substrate and the interdigital electrode portion is formed using an RF sputtering method.

Fig. 24 is a graph illustrating temperature characteristics of the surface acoustic wave devices (first embodiment and second embodiment) according to the present invention formed using the manufacturing method according to the present invention and a conventional surface acoustic wave device (comparative example g) formed using a conventional manufacturing method.

Fig. 25 is a graph illustrating resonance characteristics of the surface acoustic wave devices (first embodiment and second embodiment) according to the present invention formed using the manufacturing method according to the present invention and the conventional surface acoustic wave device (comparative example) formed using the conventional manufacturing method.

Fig. 26 is a graph illustrating a result of plotting reflection coefficients $S_{11}$ of the surface acoustic wave devices onto a Smith chart using a network analyzer.

Fig. 27 is a partial cross-sectional view illustrating a step of manufacturing the conventional surface acoustic wave device.

Fig. 28 is a partial cross-sectional view illustrating the conventional surface acoustic wave device.

## DESCRIPTION OF THE PREFERRED EMBODIMENTS

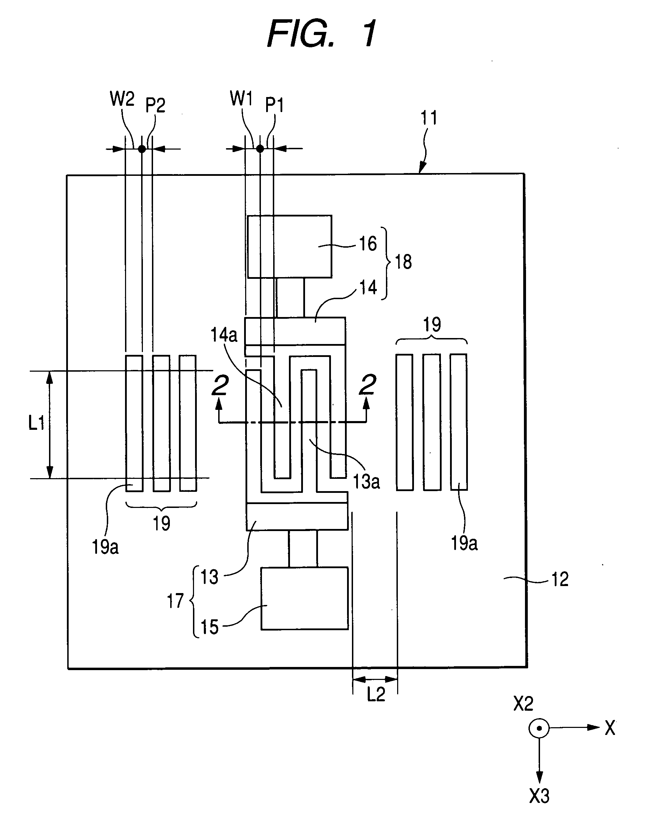

Fig. 1 is a plan view illustrating a surface acoustic wave device according to an embodiment of the present invention. A reference numeral 11 denotes a surface acoustic wave device and the surface acoustic wave device has a function as a resonator.

A reference numeral 12 denotes a piezoelectric substrate. In the present embodiment, the piezoelectric substrate 12 is made of $LiTaO_3$. An interdigital electrode portion 13 and an interdigital electrode portion 14 are formed on the piezoelectric substrate 12. Fingers 13a extending in a direction opposite to the X3 direction shown in the figure and fingers 14a extending in the X3 direction shown in the figure are provided to the interdigital electrode portion 13 and the interdigital electrode portion 14, respectively. The fingers 13a of the interdigital electrode portion 13 and the fingers 14a of the interdigital electrode portion 14 are alternately arranged in the X direction shown in the figure at a predetermined interval.

Connection electrode portions 15 and 16 connecting the surface acoustic wave device to external circuits are electrically connected to the interdigital electrode portion 13 and the interdigital electrode portion 14.

The interdigital electrode portion 13 and the connection electrode portion 15 constitute an electrode portion 17, and the interdigital electrode portion 14 and the connection electrode portion 16 constitute an electrode portion 18.

In the embodiment shown in Fig. 1, the fingers 13a of the interdigital electrode portion 13 and the fingers 14a of the interdigital electrode portion 14 have the same width W1 and a gap therebetween P1 is constant. The fingers 13a and the fingers 14a are alternated with a length L1. The width W1 is 0. 1 μm or more and 1.5 (m or less, the gap P1 is 0.1 (m or more and 1.5 (m or less, and the length L1 is 16 (m or more and 100 (m or less.

In the present embodiment, the interdigital electrode portion 13 and the interdigital electrode portion 14 are made of Al or Al alloy, or Cu or Cu alloy. The Cu alloy is an alloy containing a small amount of Ag, Sn, and C in Cu. The contents of Ag, Sn, and C as additive elements may have a range where the specific gravity of the Cu alloy is approximately equal to the specific gravity of pure Cu. Specifically, when the mass percentage of the additive elements to the Cu alloy is 0.5 % by mass or more and 10.0 % by mass or less, the specific gravity of the Cu alloy is approximately equal to the specific gravity of pure Cu.

At the X direction side of the interdigital electrode portion 13 and the interdigital electrode portion 14 and at the side opposite to the X direction side thereof, reflectors 19 and 19 in which rectangular electrodes (stripes) 19a are arranged in the X direction are formed with a predetermined distance. In Fig. 1, ends of the respective electrodes constituting the reflectors 19 are opened. However, the ends of the respective electrodes constituting the reflectors 19 may be shortcircuited.

The connection electrode portions 15 and 16 and the reflectors 19 and 19 may be made of the same material as the interdigital electrode portions 13 and 14, and may be made of a different conductive material such as Au.

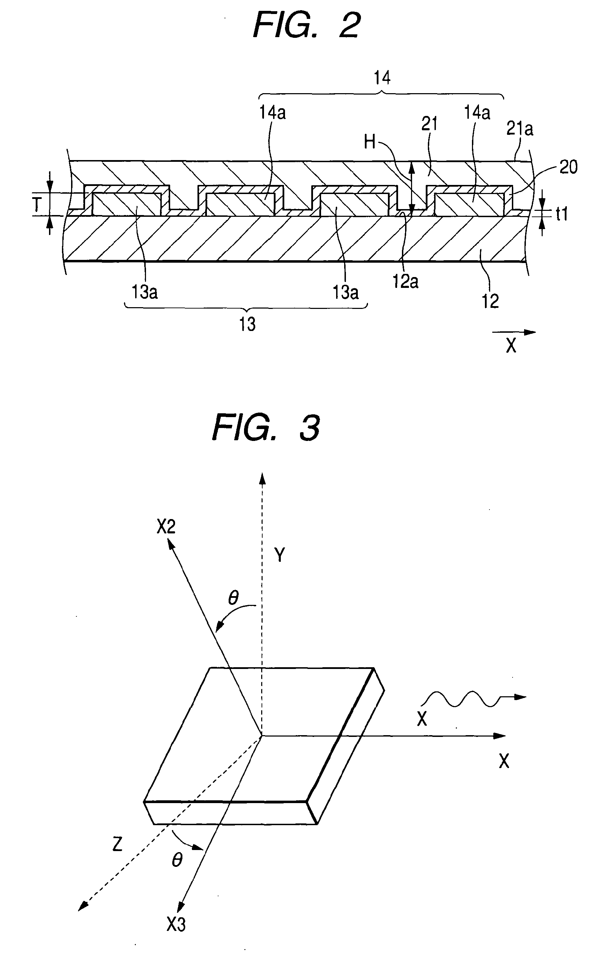

Actually, as shown in the cross-sectional view of Fig. 2, the piezoelectric substrate 12, the interdigital electrode portion 13 and 14, and the reflectors 19 and 19 are covered with an insulating thin film 20 and an insulating layer 21. The connection electrode portions 15 and 16 are not covered with the insulating layer 21 but exposed.

In Fig. 1, the insulating thin film 20 and the insulating layer 21 are omitted so as to apparently show the two-dimensional structure of the electrode portions 17 and 18 and the reflectors 19 and 19 formed on the piezoelectric substrate 12.

Fig. 2 is a vertical cross-sectional view of the interdigital electrode portion 13 and the interdigital electrode portion 14 taken along Line 2-2 of Fig. 1 and seen in the arrow direction.

The piezoelectric substrate 12 and the interdigital electrode portions 13 and 14 are covered with the insulating layer 21 with the insulating thin film 20 therebetween. The piezoelectric substrate 12 is made of LiTO3, and the insulating thin film 20 and the insulating layer 21 are made of silicon oxide (SiO2).

The thickness t of the interdigital electrode portions 13 and 14 ranges 100 nm to 200 nm, and the thickness H (the maximum value of the thickness from the upper surface 12a of the piezoelectric substrate 12 to the upper surface 21a of the insulating layer 21) of the insulating layer 21 ranges 200 nm to 300 nm.

The insulating thin film 20 is a thin film formed using the sputtering method to have a thickness of 20 nm to 40 nm, and is formed so as to suppress the deterioration of the interdigital electrode portion 13 and 14 and to improve adhesive power of the insulating layer 21.

A temperature-elastic constant variation characteristic of a substrate or an insulating layer means the direction and magnitude of an elastic constant variation when the temperature is changed. For example, when the temperature increases, the elastic constant of LiTaO3 decreases, and when the temperature increases, the elastic constant of silicon oxide increases. At this time, LiTa03 and silicon oxide have temperature-elasticity constant variation characteristics opposite to each other.

When the piezoelectric substrate 12 and the insulating layer 21 are formed using LiTaO3 and silicon oxide having temperature-elasticity constant variation characteristics opposite to each other, variations of a serial resonant frequency and a parallel resonant frequency when the device temperature is changed can be reduced.

LiTaO3 and aluminum nitride (AIN) also constitute a combination in which the temperature-elasticity constant variation characteristics are opposite to each other.

The piezoelectric substrate 12 and the interdigital electrode portions 13 and 14 are covered with the insulating layer 21, and in addition, the upper surface of the insulating layer 21 is intentionally made flat.

When the upper surface 21a of the insulating layer 21 is flat, the deterioration of the propagation efficiency of a surface acoustic wave can be suppressed, so that it is possible to reduce insertion loss of a resonator. Further, when the upper surface 21a of the insulating layer 21 is flat, it is possible to reduce the variations of the resonant frequency and the anti-resonant frequency due to the temperature change of the surface acoustic wave device, compared to the case where unevenness having large steps is formed on the upper surface 21a of the insulating layer 21.

In this way, since it is an important feature of the present invention that the upper surface 21a of the insulating layer 21 is made flat, a method of making the upper surface 21a flat will be described in detail later.

Although not shown in Fig. 2, in the present embodiment, the reflectors 19 and 19 are covered with the insulating layer 21 with the insulating thin film 20 therebetween, and the upper surface 21a of the insulating layer 21 is flat. Here, the connection electrode portions 15 and 16 are not covered with the insulating layer 21, but exposed.

In the present embodiment, the insulating layer 21 is a thin film having a uniform density. "The insulating layer 21 has a uniform density" means that the insulating material exists in all the areas without voids or cracks at the inside of the insulating layer 21, specifically, around the interdigital electrode portions. This will be described later with reference to sectional photographs of the surface acoustic wave device.

When the wavelength of a surface acoustic wave is denoted by ( and the maximum value of the thickness from the upper surface 12a of the piezoelectric substrate 12 to the upper surface 21a of the insulating layer 21 is denoted by H, the normalized thickness $H/\lambda$ of the insulating layer 21 ranges $0 < H/\lambda1 < 0.5$.

Specifically, when the normalized thickness $H/\lambda$ of the insulating layer is 0.06 or more, the absolute value of the variation of the anti-resonant frequency per temperature change of $1°C$ of the surface acoustic wave device can be set to 30 ppm/$°C$. When the normalized thickness $H/\lambda$ of the insulating layer is 0.08 or less, the reflection coefficient $S_{11}$ of the surface acoustic wave device at the anti-resonant frequency can be set to 0.9 or more.

The reflection coefficient $S_{11}$ is a parameter defining the reflection of an input wave when a signal is applied to a signal input electrode and a ground electrode of the surface acoustic wave device, and in an ideal resonator, the reflection coefficient $S_{11}$ at the anti-resonant frequency is 1. Since this means that impedance is infinite and Q of the resonator is infinite, a resonator having an excellent characteristic can be provided as the reflection coefficient $S_{11}$ approaches 1.

When one of the connection electrode portion 15 and the connection electrode portion 16 of the surface acoustic wave device 11 is set to a ground side and an RF signal is applied to the other electrode portion, surface waves are excited in the surface of the piezoelectric substrate 12 and the excited surface waves are propagated in the X direction and an anti-parallel direction of the X direction. The surface waves are reflected by the reflectors 19 and 19 and return to the interdigital electrode portions 13 and 14. The surface acoustic wave device 11 has a resonant frequency and an anti-resonant frequency, and has the highest impedance at the anti-resonant frequency.

In Fig. 3, a state where a mono crystal of $LiTaO_3$ having crystal axes X, Y, and Z is cut out at an angle tilted by a rotation angle $\theta$ from the Y axis to the Z axis about the crystal axis X is shown. Such a piezoelectric substrate is referred to as a $\theta$-rotation Y-cut $LiTaO_3$ substrate. The angel $\theta$ is referred to as a rotational cut angle or a cut angle.

The piezoelectric substrate 12 made of $LiTaO_3$ according to the present embodiment is a rotation Y-cut $LiTaO_3$ substrate of which the rotational cut angle $\theta$ (cut angle) from the Y axis to the Z axis about the X axis is 36° or more and 56° or less.

A method of manufacturing a surface acoustic wave device shown in Figs. 1 and 2 will be now described. There are various manufacturing methods of covering the piezoelectric substrate 12 and the interdigital electrode portions 13 and 14 with the insulating layer 21 and making the upper surface of the insulating layer 21 flat.

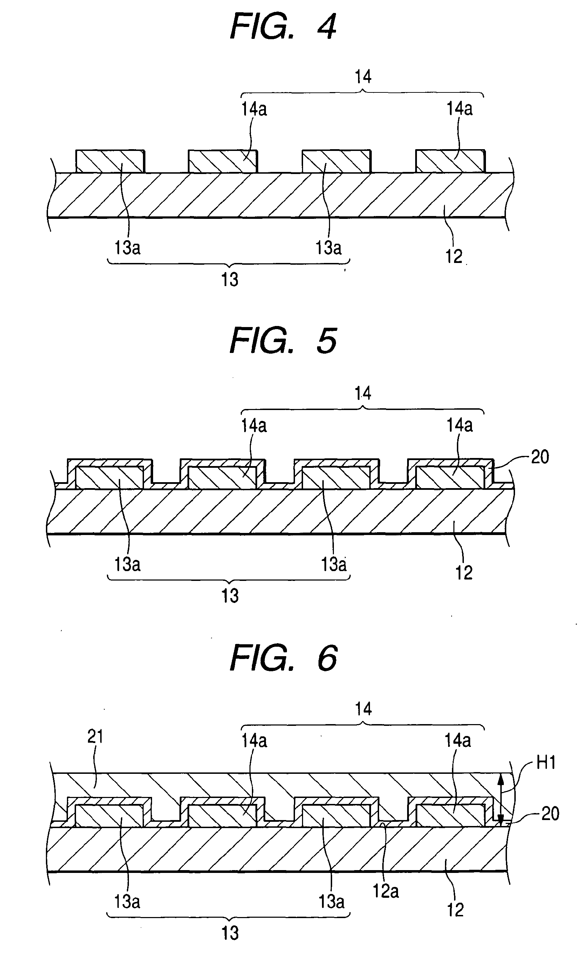

Figs. 4 to 6 are process diagrams illustrating an embodiment of the method of manufacturing a surface acoustic wave device shown in Figs. 1 and 2, and are cross-sectional view of the surface acoustic wave device at respective steps as seen in the same direction as Fig. 2.

On the piezoelectric substrate made of LiTaO$_3$ the interdigital electrode portion 13, the interdigital electrode portion 14, the connection electrode portions (not shown in Figs. 4 to 6), and the reflectors (not shown in Figs. 4 to 6) are patterned and formed using a conductive material such as Cu, Al, Au, etc. using a frame plating method. An underlying film made of Ti, etc. may be provided below the interdigital electrode portions 13 and 14 and the reflectors 19 and 19. A protective layer for preventing oxidation, which is made of Cr, etc., may be formed above the interdigital electrode portions 13 and 14 and the reflectors 19 and 19.

Next, at the step shown in Fig. 5, the insulating thin film 20 made of silicon oxide (SiO$_2$ with a thickness of 20 nm to 40 nm is formed on the piezoelectric substrate 12 and the interdigital electrode portions 13 and 14 using a sputtering method. The insulating thin film 20 is formed so as to suppress the deterioration of the interdigital electrode portions 13 and 14 and to improve adhesive power of the insulating layer 21 formed on the insulating thin film 20.

Next, at the step shown in Fig. 6, the insulating layer 21 is formed on the piezoelectric substrate 12 and the interdigital electrode portions 13 and 14 with the insulating thin film 20 therebetween.

In the present embodiment, the insulating layer 21 is made of polysilazane (produced by Clariant Japan Co., Ltd.). The polysilazane has a structure where hydrogen H is added to a ring compound of silicon Si and nitrogen N, and is coated using a spin coating method in a state where it is melted in a solvent of dibutyl ether. The formed thickness (coating thickness) of the insulating layer 21 has a range of $50 \leq H1 \leq 300$ nm.

After applying the insulating layer 21 by the spin coating method, the insulating layer is baked in a nitrogen atmosphere at a temperature of 150°C for three minutes, thereby removing the solvent of dibutyl ether. The insulating layer is cured in an atmosphere of H$_2$O at a temperature of 400°C for an hour. Through this curing step, ammonia NH$_3$ or H$_2$ is liberated, so that the insulating layer 21 becomes a layer containing silicon oxide as a major component.

The temperature-elasticity constant variation characteristic of a substrate or an insulating layer means the direction and the magnitude of variation of an elastic constant when a temperature changes. For example, the elastic constant of LiTaO$_3$ decreases when a temperature increases, and the elastic constant of silicon oxide increases when a temperature increases. At this time, it is said that LiTaO$_3$ and silicon oxide have temperature-elasticity constant variation characteristics opposite to each other. When the piezoelectric substrate 12 and the insulating layer 21 are formed out of LiTaO$_3$ and silicon oxide having temperature-elasticity constant variation characteristics opposite to each other, the variation of the serial resonant frequency and the parallel resonant frequency can be reduced.

As in the present embodiment, when the insulating layer 21 is formed using a spin-on-glass method in which the spin coating method is performed and then the baking process and the curing process are performed, the upper surface 21a of the insulating layer 21 is made flat.

Conventionally, since there was no idea that the upper surface of the insulating layer covering the piezoelectric substrate is intentionally made flat, the insulating layer was formed using the RF sputtering method. As a result, unevenness having large steps was formed on the surface of the actual insulating layer, thereby increasing the insertion loss of the surface acoustic wave device.

When the spin-on-glass method is used, the upper surface 21a of the insulating layer 21 can be surely made flat, so that it is possible to suppress the deterioration of the propagation efficiency of the surface acoustic waves and thus to reduce the insertion loss of the surface acoustic wave device. When the upper surface 21a of the insulating layer is flat, it is possible to reduce the variation of the resonant frequency and the anti-resonant frequency due to the temperature change of the surface acoustic wave device, compared to the case where the unevenness having large steps are formed on the upper surface of the insulating layer.

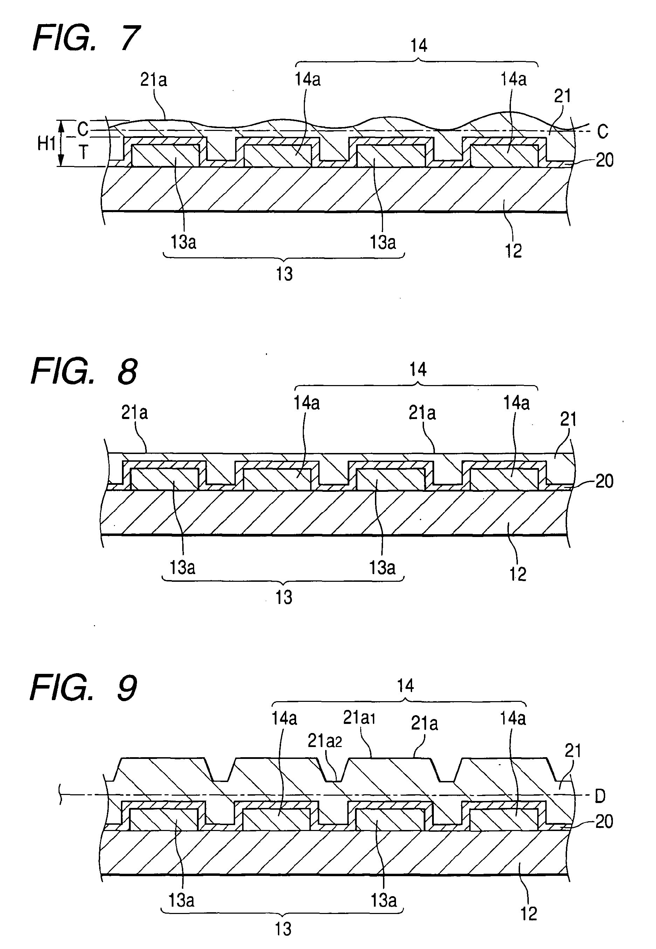

When the coated thickness of the insulating layer 21 is small and the ratio between the thickness T of the interdigital electrode portions 13 and 14 and the coated thickness H1 of the insulating layer is small, the upper surface 21a of the insulating layer 21 after the coating process, the baking process, and the curing process may wave as shown in Fig. 7. At this time, the upper surface 21a of the insulating layer 21 of Fig. 7 may be subjected to the CMP (Chemical Mechanical Polishing) process, thereby making the upper surface flat as shown in Fig. 8.

As a raw material of the insulating layer 21, silsesquioxane hydride, silicate, siloxane, etc. may be used in addition to polysilazane (produced by Clariant Japan Co., Ltd.)

A method may be used in addition to the spin-on-glass method, only if it can make the upper surface 21a of the insulating layer 21 flat. For example, the insulating layer 21 may be formed by one of a bias sputtering method, a bias CVD method, and an atmospheric CVD method, thereby making the upper surface 21a of the insulating layer 21 flat.

When the insulating layer 21 is formed by one of the spin-on-glass method, the bias sputtering method, the bias CVD method, and the atmospheric CVD method, the insulating layer 21 can be formed with a uniform density. In the present invention, "the insulating has a uniform density" means that the insulating material exists in the whole area without voids or cracks at the inside of the insulating layer, specifically, around the interdigital electrode portions.

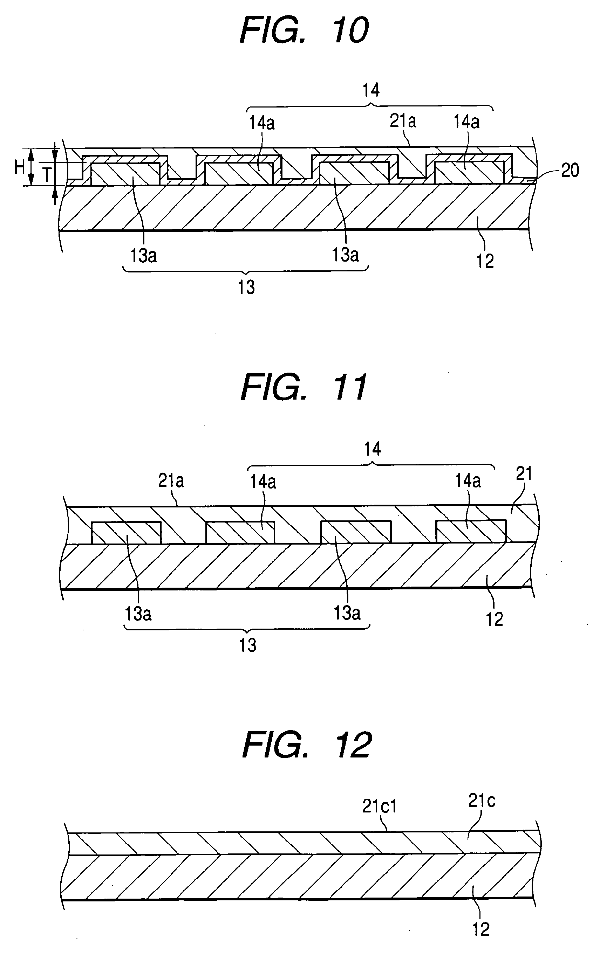

When the insulating layer 21 is formed using the sputtering method after the step shown in Fig. 5, convex portions 21a1 on the interdigital electrode portions 13 and 14 and concave portions 21a2 on between the interdigital electrode portions are formed in the upper surface of the insulating layer 21 as shown in Fig. 9. However, by forming the insulating layer 21 made of silicon oxide on the piezoelectric substrate 12 and the interdigital electrode portions 13 and 14 with the insulating thin film 20 therebetween using the RF sputtering method or the CVD method, and then performing the CMP (Chemical Mechanical Polishing) process up to the portion indicated by a dot-dashed line D-D, the upper surface 21a of the insulating layer 21 can be made flat as shown in Fig. 10.

However, when the insulating layer 21 is formed using the RF sputtering method or the CVD method, voids or cracks are generated at the inside of the insulating layer 21, specifically, around the interdigital electrode portions, so that the insulating layer 21 may not become a thin film having a uniform density.

In the aforementioned embodiments, after the insulating thin film 20 is formed on the piezoelectric substrate 12 and the interdigital electrode portions 13 and 14, the insulating layer 21 made of silicon oxide is stacked thereon. However, as shown in Fig. 11, the insulating layer 21 made of silicon oxide may be directly stacked on the piezoelectric substrate 12 and the interdigital electrode portions 13 and 14.

Figs. 12 to 15 are diagrams illustrating steps of another embodiment of the manufacturing method according to the present invention, and are cross-sectional views of the surface acoustic wave device at respective steps as seen in the same direction as Fig. 2.

At the step shown in Fig. 12, an insulating layer 21c, which is made of silicon oxide and has a flat upper surface 21c1, is formed on the piezoelectric substrate 12 made of $LiTaO_3$. The insulating layer 21c may be formed using any one of the spin-on-glass method, the bias sputtering method, the bias CVD method, the atmospheric CVD method, the RF sputtering method, and the CVD method.

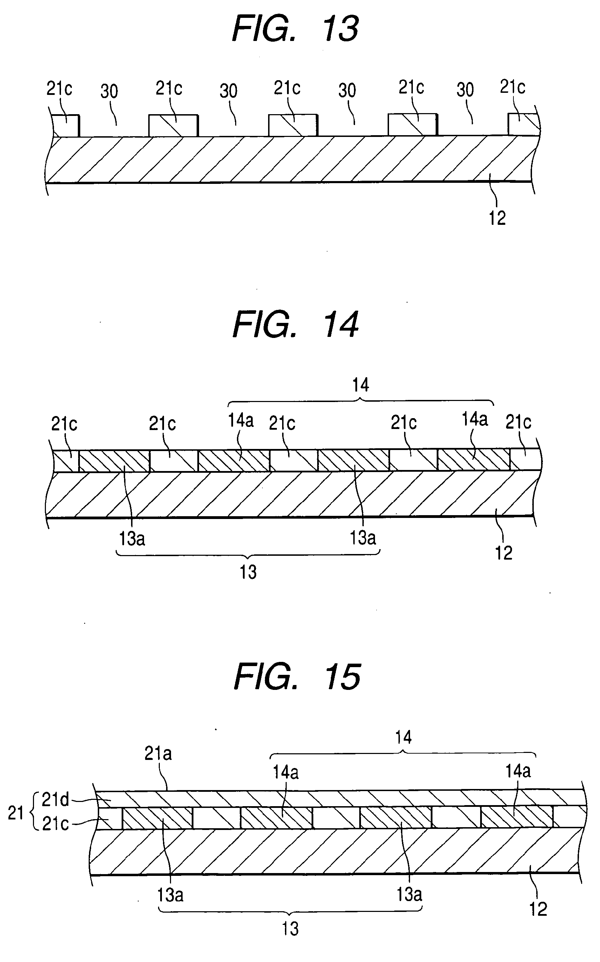

Next, at the step shown in Fig. 13, concave portions 30 having a shape of the interdigital electrode portions 13 and 14 are patterned and formed in the surface of the insulating layer 21c. At this time, the concave portions 30 having shapes of the connection electrode portions (not shown in Figs. 12 to 15) and the reflectors (not shown in Figs. 12 to 15) may be also patterned and formed.

Next, at the step shown in Fig. 14, the interdigital electrode portion 13 and the interdigital electrode portion 14 are formed at the insides of the concave portions 30 using a conductive material such as Cu, Al, Au, etc. using the sputtering method or the plating method. For example, by stacking the conductive material such as Cu, Al, Au, etc. at the insides of the concave portions 30 and on the whole surface of the insulating layer 21c using the sputtering method or the plating method, and then performing the CMP (Chemical Mechanical Polishing) process, the upper surface of the interdigital electrode portion 13, the upper surface of the interdigital electrode portion 14, and the upper surface of the insulating layer 21c may form the same flat plane. Alternatively, a method of patterning and forming the concave portions 30 of Fig. 13 using a resist photolithography and etching process employing a lift-off resist, forming the interdigital electrode portion 13 and the interdigital electrode portion 14 at the insides of the concave portions 30 using the conductive material such as Cu, Al, Au, etc. using the sputtering method or the plating method and using the lift-off resist as a mask, and then removing the lift-off resist may be employed.

Preferably, the connection electrode portions (not shown in Figs. 12 to 15) and the reflectors (not shown in Figs. 12 to 15) may be formed at the same time as forming the interdigital electrode portions 13 and 14. An underlying film made of Ti, etc. may be formed below the interdigital electrode portions 13 and 14 and the reflectors. Further, a protective layer for preventing oxidation, which is made of Cr, may be formed above the interdigital electrode portions 13 and 14 and the reflectors.

Next, an insulating layer 21d is formed on the insulating layer 21c and the interdigital electrode portions 13 and 14 using silicon oxide. The insulating layer 21d may be formed using any one of the spin-on-glass method, the bias sputtering method, the bias CVD method, the atmospheric CVD method, the RF sputtering method, and the CVD method.

The insulating layer 21c and the insulating layer 21d constitute the insulating layer 21 shown in Fig. 2. Since the upper surface of the interdigital electrode portion 13, the upper surface of the interdigital electrode portion 14, and the upper surface of the insulating layer 21c form a flat plane, the upper surface of the insulating layer 21d, that is, the upper surface 21a of the insulating layer 21 becomes a flat plane.

The present invention does not require that the upper surface 21a of the insulating layer 21 should be completely flat.

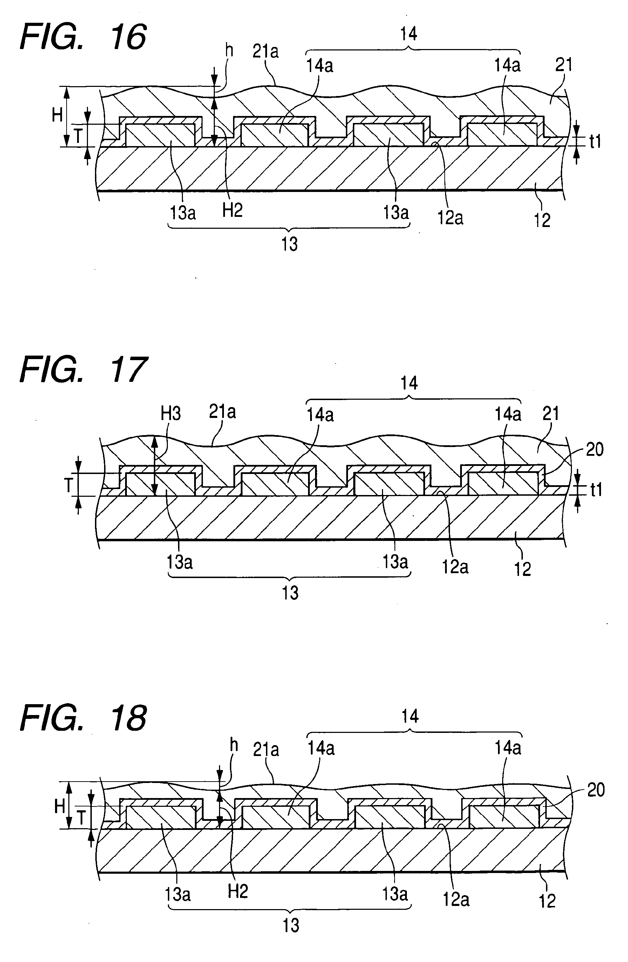

As shown in Fig. 16, even when the upper surface 21a of the insulating layer 21 slightly waves, the rate of flatness S (%) of the upper surface of the insulating layer expressed by the following equation is preferably 50 % or more, where T denotes the thickness of the interdigital electrode portions 13 and 14 and h denotes a difference between the maximum value H and the minimum value $H_2$ of the thickness from the upper surface 12a of the piezoelectric substrate 12 to the upper surface 21a of the insulating layer 21.

$$S = \left(1 - \frac{h}{T}\right) \times 100 \quad (\%)$$

Further, as shown in Fig. 17, a so-called etch-back method in which the insulating layer 21 is formed on the piezoelectric substrate 12 and the interdigital electrode portions 13 and 14 using silicon oxide with a large thickness of $H_3$, making the rate of flatness of the upper surface 21a of the insulating layer 21 50 % or more, and then thinning the insulating layer 21 using an etching method as shown in Fig. 8 may be employed.

When the piezoelectric substrate 12 is made of $LiTaO_3$, the insulating thin film 20 and the insulating layer 21 may be made of aluminum nitride. $LiTaO_3$ and aluminum nitride have temperature-elasticity constant variation characteristic opposite to each other.

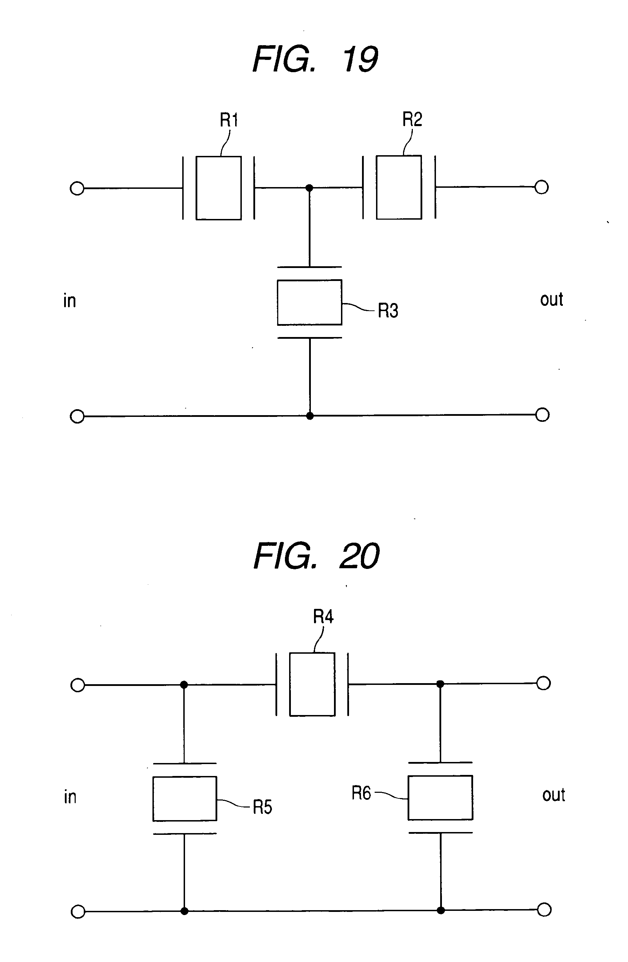

In Figs. 19 and 20, examples of a filter formed using the surface acoustic wave device shown in Figs. 1 and 2 are illustrated.

In Fig. 19, reference numerals R1, R2, and R3 denote the surface acoustic wave device 11 shown in Fig. 1 as one unit, respectively. The filter shown in Fig. 19, which is referred to as a T type filter, comprises three surface acoustic wave devices, wherein the surface acoustic wave device R1 and the surface acoustic wave device R2 are connected in series to each other through the connection electrode portions, one connection electrode of the surface acoustic wave device R1 is an input terminal in, and one connection electrode of the surface acoustic wave device R2 is an output terminal out. One connection electrode of the surface acoustic wave device R3 is connected between the surface acoustic wave device R1 and the surface acoustic wave device R2, and the other connection electrode thereof is grounded.

In Fig. 20, reference numerals R4, R5, and R6 denote the surface acoustic wave device 11 shown in Figs. 1 and 2 as one unit, respectively. In Fig. 20, among three surface acoustic wave devices, the surface acoustic wave device R5 and the surface acoustic wave device R6 are connected to each other in parallel, and the surface acoustic wave device R4 is inserted between the surface acoustic device R5 and the surface acoustic wave device R6.

That is, one connection electrode of the surface acoustic wave device R4 is an input terminal in, and the other connection electrode thereof is an output terminal out. Further, one connection electrode of the surface acoustic wave device R5 is an input terminal in, and the other connection electrode thereof is grounded. Furthermore, one connection electrode of the surface acoustic wave device R6 is an output terminal out, and the other connection electrode thereof is grounded. The filter shown in Fig. 20 is a so-called $\pi$ type filter.

(Embodiments)

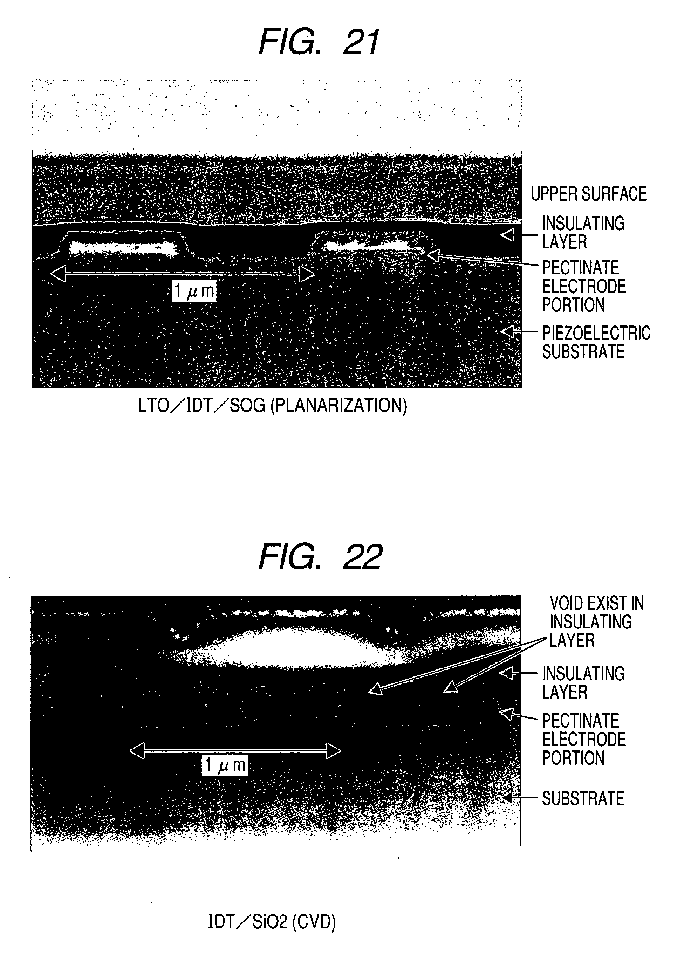

Fig. 21 shows a sectional photograph of the surface acoustic wave device according to the present invention, in which the insulating layer covering the piezoelectric substrate and the interdigital electrode portions is formed using the spin-on-glass method.

The interdigital electrode portions are formed on the piezoelectric substrate made of $LiTaO_3$ using the conductive material Cu, Al, Au, etc. using the frame plating method, etc., and the insulating thin film 20 having a thickness of 20 nm to 40 nm is formed on the piezoelectric substrate 12 and the interdigital electrode portions 13 and 14 using the sputtering method. Next, polysilazane (produced by Clariant Japan Co., Ltd.) is applied using the spin coating method, then dibytyl ether solvent is removed by baking the coating film in an atmosphere of nitrogen at a temperature of 150°C for 3 minutes, and then a curing process is performed in an atmosphere of $H_2O$ at a temperature of 400°C for an hour. Through this curing process, ammonia $NH_3$ is liberated, so that the insulating layer containing silicon oxide as a major component is formed on the insulating thin film.

The width of the fingers of the interdigital electrode portions is 0.5 $\mu$m, and the gap between the fingers of the interdigital electrode portions is 0.5 $\mu$m. The thickness of the interdigital electrode portions is 100 nm, and the thickness from the upper surface of the piezoelectric substrate to the upper surface of the insulating layer is 0.2 $\mu$m.

As shown in Fig. 21, the upper surface of the insulating layer covering the piezoelectric substrate and the interdigital electrode portions is flat. The insulating material exists in the whole area without voids or cracks at the inside of the insulating layer, specifically, around the interdigital electrode portions. That is, the insulating layer is a thin film having a uniform density.

As Comparative example 1, a sectional photograph of the surface acoustic wave device in which the insulating layer covering the piezoelectric substrate and the interdigital electrode portions is formed using the CVD method is shown in Fig. 22. The material and the measurements of the piezoelectric substrate and the interdigital electrode portions are equal to those of the surface acoustic device shown in Fig. 21. The insulating layer is made of silicon oxide, and the maximum value of the thickness from the surface of the piezoelectric substrate to the upper surface of the insulating layer is 0.65 $\mu$m.

When the insulating layer is formed using only the CVD method, concave portions and convex portions are formed in the upper surface of the insulating layer covering the piezoelectric substrate and the interdigital electrode portions, as shown in Fig. 22. In addition, voids exist at the inside of the insulating layer, specifically, around the interdigital electrode portions, so that the insulating layer cannot be said to be a thin film having a uniform density.

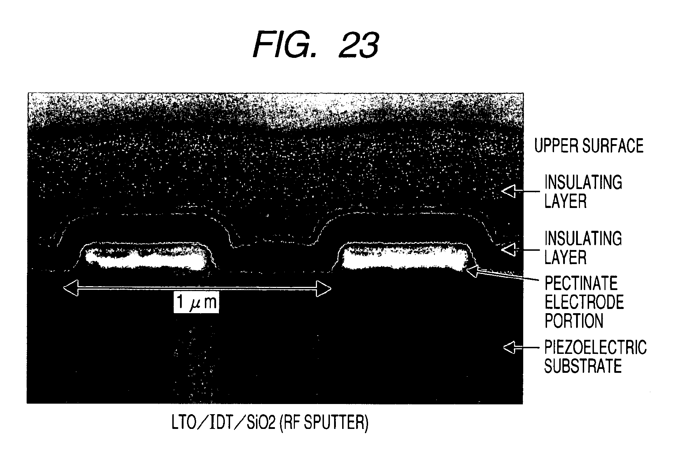

As Comparative example 2, a sectional photograph of the surface acoustic wave device in which the insulating layer covering the piezoelectric substrate and the interdigital electrode portions are formed using only the RF sputtering method is shown in Fig. 23. The material and the measurements of the piezoelectric substrate and the interdigital electrode portions are equal to those of the surface acoustic device shown in Fig. 21. The insulating layer is made of silicon oxide, and the maximum value of the thickness from the surface of the piezoelectric substrate to the upper surface of the insulating layer is 0.3 $\mu$m.

When the insulating layer is formed using only the RF sputtering method, concave portions and convex portions are formed in the upper surface of the insulating layer covering the piezoelectric substrate and the interdigital electrode portions, as shown in Fig. 23.

Next, the temperature characteristics and the resonance characteristics of the surface acoustic wave device according to the present invention, which is formed using the manufacturing method according to the present invention, and the conventional surface acoustic wave device, which is formed using the conventional manufacturing method, will be compared with each other.

The surface acoustic wave device (first embodiment) according to the present invention is manufactured through the following steps, similarly to the surface acoustic wave device shown in Fig. 21.

First, the interdigital electrode portions are formed on the piezoelectric substrate using a conductive material by means of a sputtering process, a resist photolithography process, and an etching process, and the insulating thin film made of silicon oxide having a thickness of 20 nm to 40 nm is formed on the piezoelectric substrate and the interdigital electrode portions using the sputtering method. Next, polysilazane (produced by Clariant Japan Co., Ltd.) is applied thereon using the spin coating method, the dibutyl ether solvent is removed by baking the coating film in an atmosphere of nitrogen at a temperature of 150°C for 3 minutes, and then a curing process is performed in an atmosphere of $H_2O$ for an hour. Through the curing process, ammonia $NH_3$ and $H_2$ are liberated, so that the insulating layer containing silicon oxide as a major component is formed on the insulating thin film.

The surface acoustic wave device according to a second embodiment of the present invention is manufactured through the following steps. First, the interdigital electrode portions are formed on the piezoelectric substrate using a conductive material. Thereafter, the insulating layer covering the piezoelectric substrate and the interdigital electrode portions is formed using the bias sputtering method.

The conventional surface acoustic wave device (comparative example) is formed through the same steps as the surface acoustic wave device shown in Fig. 23. First, the interdigital electrode portions are formed on the piezoelectric substrate using a conductive material. Thereafter, the insulating layer covering the piezoelectric substrate and the interdigital electrode portions is formed using the RF sputtering method.

The shapes of the surface acoustic wave device (first embodiment and second embodiment) according to the present invention is similar to that of the surface acoustic wave device shown in Fig. 21, and the shape of the conventional surface acoustic wave device (comparative example) is similar to that of the surface acoustic wave device shown in Fig. 23.

The measurements of the interdigital electrode portions and the reflectors are described below. The measurements of the interdigital electrode portions and the reflectors are common to the surface acoustic wave device according to the present invention and the convention surface acoustic wave device.

The width W1 of each finger of the interdigital electrode portions and the width W2 of each stripe of the reflectors: W1 = W2 = 0.4 $\mu$m to 0.545 $\mu$m

The gap P1 between the fingers of the interdigital electrode portions and the gap P2 between the stripes of the reflectors: P1 = P2 = 0.4 $\mu$m to 0.545 $\mu$m

The length L1 with which the fingers 13a and the fingers 14a: L1 = 40 $\times$ (wavelength $\lambda$ of surface acoustic wave) = 40 $\times$ 2 $\times$ (W1+P1)

The thickness of the interdigital electrode portions and the thickness of the stripes of the reflectors: H = 0.095 $\mu$m

The number of fingers of each interdigital electrode portion: 200

The number of stripes of each reflector: 50

The distance between the interdigital electrode portions and the reflectors: L2 = P1 = 0.4 $\mu$m to 0.545 $\mu$m

The piezoelectric substrate is made of $LiTaO_3$. In the present embodiment, the input frequency is set to the anti-resonant frequency (1.7 GHz to 2.1 GHz in the present embodiment). The interdigital electrode portions and the reflectors are made of $Cu_{97.0}Ag_{3.0}$ alloy.

The thickness from the surface of the piezoelectric substrate to the upper surface of the insulating layer in the surface acoustic wave device (first embodiment) according to the present invention ranges 0.15 μm to 0.25 μm. The thickness from the surface of the piezoelectric substrate to the upper surface of the insulating layer in the surface acoustic wave device according to the second embodiment ranges 0.05 μm to 0.30 μm.

The maximum value of the thickness from the surface of the piezoelectric substrate to the upper surface of the insulating layer in the conventional surface acoustic wave device (comparative example 2) in which the insulating layer is formed using the RF sputtering method ranges 0.05 μm to 0.20 μm.

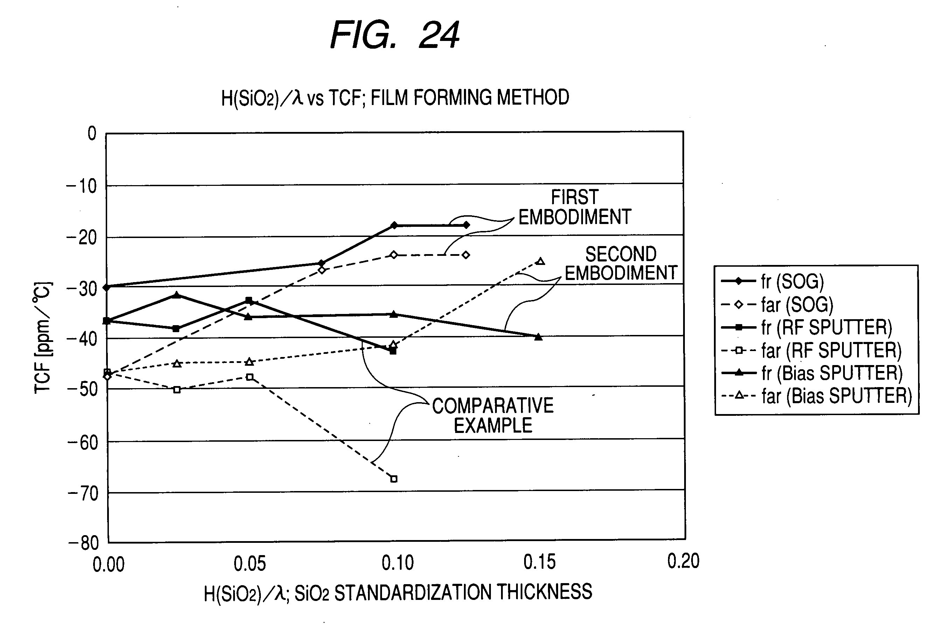

The temperature characteristics of the surface acoustic wave device (first embodiment and second embodiment) according to the present invention which is formed using the manufacturing method according to the present invention and the conventional surface acoustic wave device (comparative example) which is formed using the conventional manufacturing method are shown in Fig. 24.

The axis of abscissas in the graph shown in Fig. 24 indicates the normalized thickness H/λ of the insulating layer and the axis of ordinates indicates variations of the resonant frequency and the anti-resonant frequency due to the temperature change of the surface acoustic wave device. The normalized thickness H/λ of the insulating layer is obtained by dividing the maximum value H of the thickness from the surface of the piezoelectric substrate to the upper surface of the insulating layer by the wavelength λ of the surface acoustic wave propagated through the surface of the piezoelectric surface. The solid line indicates the variation of the resonant frequency and the dotted line indicates the variation of the anti-resonant frequency.

When the insulating layer containing silicon oxide as a major component is formed on the piezoelectric substrate and the interdigital electrode portions using the spin-on-glass (SOG) method and the surface of the insulating layer is made flat (first embodiment), the variations of the resonant frequency and the anti-resonant frequency due to the temperature change of the surface acoustic wave device is smaller than a case where the RF sputtering method or the bias sputtering method is used. The variations of the anti-resonant frequency and the resonant frequency due to the temperature change decrease as the normalized thickness H/λ increases.

In this way, even when the frequency of input signals lies in a high frequency band of 1.5 GHz to 2.5 GHz, the surface acoustic wave device according to the first embodiment can set the absolute values of the variations of the anti-resonant frequency and the resonant frequency due to the temperature change to 30 ppm/°C or less, or 25 ppm/°C or less. In addition, even when the frequency of the input signals lies in a high frequency band of 1.5 GHz to 2.5 GHz, the surface acoustic wave device according to the second embodiment can set the absolute values of the variations of the anti-resonant frequency and the resonant frequency due to the temperature change to 40 ppm/°C or less, or 30 ppm/°C or less.

In the present invention, the resonance characteristic of the surface acoustic wave device is estimated on the basis of the reflection coefficient $S_{11}$.

The reflection coefficient $S_{11}$ is a parameter defining the reflection of input waves when signals are applied between a signal input electrode and a ground electrode of a surface acoustic wave resonator, and in an ideal resonator, the reflection coefficient $S_{11}$ is 1. Since this means that the impedance is infinite and Q of the resonator is infinite at the anti-resonant frequency, the resonator has more excellent characteristics as the reflection coefficient S11 approaches 1.

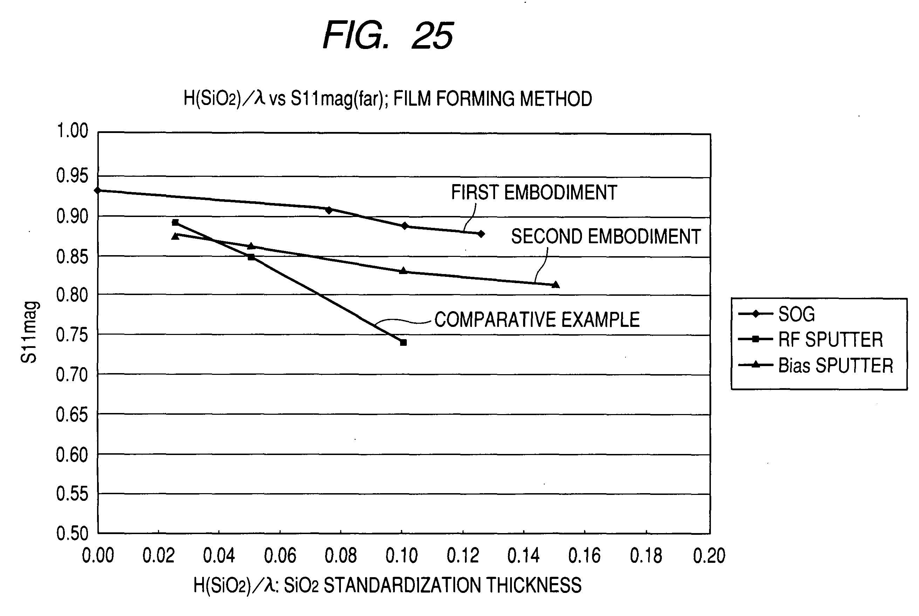

The resonance characteristics of the surface acoustic wave devices (first embodiment and second embodiment) according to the present invention manufactured using the manufacturing method according to the present invention and the conventional surface acoustic wave device (comparative example) manufactured using the conventional manufacturing method are shown in Fig. 25.

The axis of abscissas in the graph shown in Fig. 25 indicates the normalized thickness H/λ of the insulating layer and the axis of ordinates indicates the reflection coefficient S11 at the anti-resonant frequency.

When the insulating layer made of silicon oxide is formed on the piezoelectric substrate and the interdigital electrode portions using the spin-on-glass (SOG) method (first embodiment), the decrease rate of the reflection coefficient $S_{11}$ due to the increase of the normalized thickness H/λ becomes smaller than that of the comparative example in which the insulating layer is formed using the RF sputtering method. The decrease rate of the reflection coefficient $S_{11}$ due to the increase of the normalized thickness H/λ in the second embodiment in which the insulating layer is formed using the bias sputtering method is greater than that of the first embodiment, but smaller than that of the comparative example.

When the normalized thickness H/λ has a constant value, the reflection coefficient $S_{11}$ of the surface acoustic wave device (first embodiment) in which the insulating layer made of silicon oxide is formed using the spin-on-glass (SOG) method is always greater than that of the second embodiment employing the bias sputtering method or that of the comparative example employing the RF sputtering method. It is possible to set the reflection coefficient $S_{11}$ of the surface acoustic wave device according to the first embodiment to 0.90 or more.

A graph illustrating a result of plotting reflection coefficients $S_{11}$ of the surface acoustic wave devices onto a Smith chart using a network analyzer is shown in Fig. 26. The normalized thickness H/λ is 0.10.

Referring to Fig. 26, it can be seen that the surface acoustic wave device (first embodiment and second embodiment) in which the insulating layer containing silicon oxide as a major component is formed on the piezoelectric substrate and the interdigital electrode portions has a reflection coefficient $S_{11}$ smaller than that of the surface acoustic wave device in which such an insulating layer is not formed.

The first embodiment in which the insulating layer containing silicon oxide as a major component is formed on the piezoelectric substrate and the interdigital electrode portions using the spin-on-glass (SOG) method and the surface of the insulating layer is made flat most approaches a circle, the second embodiment in which the insulating layer made of silicon oxide is formed on the piezoelectric substrate and the interdigital electrode portions using the bias sputtering method next approaches a circle, and the comparative example in which the insulating layer is formed using the RF sputtering method is most different from a circle. That is, in the first embodiment in which the insulating layer made of silicon oxide is formed using the spin-on-glass (SOG) method and the second embodiment in which the insulating layer is formed using the bias sputtering method, the reflection coefficient $S_{11}$ are always closer to 1 than that of the comparative example in which the insulating layer is formed using the RF sputtering method. Therefore, the surface acoustic wave devices according to the first embodiment and the second embodiment have the smaller insertion loss and the more excellent resonance characteristic than the surface acoustic wave device according to the comparative example.

## Claims

1. A surface acoustic wave device having a piezoelectric substrate and an interdigital electrode portion formed thin on the piezoelectric substrate,
   wherein the piezoelectric substrate is covered with an insulating layer made of an insulating material having a temperature-elasticity constant variation characteristic opposite to the temperature-elasticity constant variation characteristic of the piezoelectric substrate, and the upper surface of the insulating layer is flat.

2. The surface acoustic wave device according to Claim 1, wherein the interdigital electrode portion is covered with the insulating layer and the upper surface of the insulating layer is flat.

3. The surface acoustic wave device according to Claim 1 or 2, wherein when the thickness of the interdigital electrode portion is denoted by T and a difference between the maximum and the minimum of the thickness from the upper surface of the piezoelectric substrate to the upper surface of the insulating layer is denoted by h, the rate of flatness S (%) of the upper surface of the insulating layer expressed by the following equation is 50% or more:

$$ S \ = \ \left( 1 \ - \ \frac{h}{T} \right) \times 100 \quad (\%) $$

4. The surface acoustic wave device according to any of Claims 1 to 3, wherein the insulating layer is a thin film having a uniform density.

5. The surface acoustic wave device according to any of Claims 1 to 4, wherein when the wavelength of the surface wave propagated through the surface of the piezoelectric substrate is denoted by λ and the maximum value of the thickness ranging from the upper surface of the piezoelectric substrate to the upper surface of the insulating layer is denoted by H, a normalized thickness H/λ of the insulating layer has a range of 0 < H/λ < 0.5.

6. The surface acoustic wave device according to any of Claims 1 to 5, wherein an insulating thin film formed using a sputtering method exists between the interdigital electrode portion and piezoelectric substrate and the insulating layer, and when the wavelength of the surface wave propagated through the surface of the piezoelectric substrate is denoted by λ and the thickness of the insulating thin film is denoted by t1, a normalized thickness t1/λ of the insulating thin film has a range of 0 < t1/λ < 0.1.

7. The surface acoustic wave device according to any of Claims 1 to 6, wherein the piezoelectric substrate is made of LiTaO3 and the insulating material is one of silicon oxide and aluminum nitride.

8. A method of manufacturing a surface acoustic wave device, the method comprising the steps of:

(a) patterning and forming an interdigital electrode portion on a piezoelectric substrate using a conductive material; and
(b) coating the piezoelectric substrate with an insulating material having a temperature-elasticity constant variation characteristic opposite to the temperature-elasticity constant variation characteristic of the piezoelectric substrate, forming an insulating layer, and making the insulating layer flat.

9. The method of manufacturing a surface acoustic wave device according to Claim 8, the method further comprising step (c) of heating the insulating layer after step (b).

10. The method of manufacturing a surface acoustic wave device according to Claim 8 or 9, wherein the piezoelectric substrate is made of LiTaO3 and the insulating layer is formed using silicon compound as the insulating material to include silicon oxide as a major component.

11. The method of manufacturing a surface acoustic wave device according to any of Claims 8 to 10, the method further comprising step (d) of forming on the interdigital electrode portion and the piezoelectric substrate an insulating thin film having a normalized thickness $t1/\lambda$ ranging $0 < t1/\lambda < 0.1$ using a sputtering method, where $\lambda$ denotes the wavelength of a surface wave propagated through the surface of the piezoelectric substrate and t1 denotes the thickness of the insulating thin film, between step (a) and step (b).

12. The method of manufacturing a surface acoustic wave device according to any of Claims 8 to 11, wherein at step (b), the insulating layer is formed to have a uniform density.

13. The method of manufacturing a surface acoustic wave device according to any of Claims 8 to 12, wherein at step (b), when the thickness of the interdigital electrode portion is denoted by T and a difference between the maximum value and the minimum value of the thickness from the upper surface of the piezoelectric substrate to the upper surface of the insulating layer is denoted by h, the rate of flatness S (%) of the upper surface of the insulating layer expressed by the following equation is 50% or more:

$$S \; = \; \left( 1 \; - \; \frac{h}{T} \right) \times 100 \quad (\%) \quad .$$

14. A method of manufacturing a surface acoustic wave device, the method comprising the steps of:

(e) patterning and forming an interdigital electrode portion on a piezoelectric substrate using a conductive material;
(f) coating the piezoelectric substrate with an insulating material having a temperature-elasticity constant variation characteristic opposite to the temperature-elasticity constant variation characteristic of the piezoelectric substrate, and forming an insulating layer; and
(g) polishing or etching the upper surface of the insulating layer to make the upper surface of the insulating layer flat.

15. A method of manufacturing a surface acoustic wave device, the method comprising the steps of:

(h) patterning and forming an interdigital electrode portion on a piezoelectric substrate using a conductive material; and
(i) forming an insulating layer on the piezoelectric substrate using an insulating material having a temperature-elasticity constant variation characteristic opposite to the temperature-elasticity constant variation characteristic of the piezoelectric substrate, by one of a bias sputtering method, a bias CVD method, and an atmospheric CVD method, and making the upper surface of the insulating layer flat.

16. The method of manufacturing a surface acoustic wave device according to Claim 14 or 15, wherein the piezoelectric substrate is made of $LiTaO_3$ and one of silicon oxide and aluminum nitride is used as the insulating material.

**17.** A method of manufacturing a surface acoustic wave device, the method comprising the steps of:

(j) forming on the piezoelectric substrate an insulating layer having a flat upper surface using an insulating material having a temperature-elasticity constant variation characteristic opposite to the temperature-elasticity constant variation characteristic of the piezoelectric substrate;

(k) patterning and forming on the surface of the insulating layer a concave portion having a shape of an interdigital electrode portion; and

(l) forming the interdigital electrode portion in the concave portion.

**18.** The method of manufacturing a surface acoustic wave device according to Claim 17, the method further comprising step (m) of forming another insulating layer on the insulating layer and the interdigital electrode portion using the insulating material and making the upper surface of the another insulating layer flat, after step (1).

**19.** A method of manufacturing a surface acoustic wave device, the method comprising the steps of:

(n) patterning and forming an interdigital electrode portion on a piezoelectric substrate using a conductive material;

(o) forming on the piezoelectric substrate an insulating layer using an insulating material having a temperature-elasticity constant variation characteristic opposite to the temperature-elasticity constant variation characteristic of the piezoelectric substrate by one of a sputtering method and a CVD method; and

(p) polishing or etching the upper surface of the insulating layer to make the upper surface of the insulating layer flat.

# FIG. 1

# FIG. 2

# FIG. 3

## FIG. 4

14

14a          14a

13a          13a          12

13

## FIG. 5

14

14a          14a
                                    20

13a          13a          12

13

## FIG. 6

21          14

14a          14a
                                    H1

                                    20

13a          13a    12a    12

13

*FIG. 7*

*FIG. 8*

*FIG. 9*

# FIG. 10

# FIG. 11

# FIG. 12

## FIG. 13

## FIG. 14

## FIG. 15

FIG. 16

FIG. 17

FIG. 18

## FIG. 19

## FIG. 20

## FIG. 21

UPPER SURFACE

INSULATING LAYER

PECTINATE ELECTRODE PORTION

PIEZOELECTRIC SUBSTRATE

LTO／IDT／SOG (PLANARIZATION)

## FIG. 22

VOID EXIST IN INSULATING LAYER

INSULATING LAYER

PECTINATE ELECTRODE PORTION

SUBSTRATE

IDT／SiO2 (CVD)

# FIG. 23

UPPER SURFACE

INSULATING LAYER

INSULATING LAYER

PECTINATE ELECTRODE PORTION

PIEZOELECTRIC SUBSTRATE

1 μm

LTO／IDT／SiO2 (RF SPUTTER)

# FIG. 24

## H(SiO₂)/λ vs TCF; FILM FORMING METHOD

FIRST EMBODIMENT

SECOND EMBODIMENT

COMPARATIVE EXAMPLE

Legend:
- fr (SOG)
- far (SOG)
- fr (RF SPUTTER)
- far (RF SPUTTER)
- fr (Bias SPUTTER)
- far (Bias SPUTTER)

Y-axis: TCF [ppm/℃]

X-axis: H(SiO₂)/λ; SiO₂ STANDARDIZATION THICKNESS

EP 1 544 998 A2

FIG. 25

H(SiO2)/λ vs S11mag(far); FILM FORMING METHOD

SOG
RF SPUTTER
Bias SPUTTER

FIRST EMBODIMENT

SECOND EMBODIMENT

COMPARATIVE EXAMPLE

S11mag

H(SiO2)/λ: SiO2 STANDARDIZATION THICKNESS

FIG. 26

Smithchart; H(SiO2)/λ=0.10

COMPARATIVE EXAMPLE
SECOND EMBODIMENT
FIRST EMBODIMENT
NO INSULATING LAYER

— SOG
— RF SPUTTER
— Bias SPUTTER
— NO SOG2

Im(S11)

Re(S11)

FIG. 27
PRIOR ART

2

FIG. 28
PRIOR ART

3  3a  2  3b    3a  2  3b    3a  2  3b    3a  2  3b

3c

1